# EUROPEAN PATENT SPECIFICATION

(11) **EP 3 133 332 B1**
(45) Date of publication and mention of the grant of the patent: **12.09.2018**
(21) Application number: 15178847.8
(22) Date of filing: 29.07.2015
(51) Int. Cl.: F21K 9/00, F21V 19/00, F21V 23/00, H05K 1/14, F21Y 115/10

(54) **INTEGRATED LED MODULE WITH IMS SUBSTRATE**
INTEGRIERTES LED-MODUL MIT IMS-SUBSTRAT
MODULE DE DEL INTÉGRÉ À UN SUBSTRAT IMS

(43) Date of publication of application: 22.02.2017
(73) Proprietor: Tridonic Jennersdorf GmbH, 8380 Jennersdorf (AT)
(72) Inventor: Bakk, Istvan, 2045 Torokbalint (HU)
(74) Representative: Rupp, Christian

(56) References cited:
- EP-A1- 0 852 397
- EP-A1- 2 665 133
- WO-A1-2010/060420
- WO-A1-2012/055852
- DE-A1-102010 043 220
- DE-A1-102012 221 229
- US-A1- 2011 204 780
- US-A1- 2012 187 830
- US-A1- 2015 159 816

## Description

### Field of the invention

The present invention relates to a LED module comprising an insulated metal substrate. In particular the invention relates to an integrated LED module with insulated metal substrate and advanced circuitry.

### Background of the invention

In the prior art, LED Modules comprising an insulated metal substrate (IMS) are known, on which substrate one or more LED Chips are arranged. The insulated metal substrate usually comprises a metal sheet base covered by an insulating layer of dielectric material such as resin or ceramic material. The dielectric material ensures the insulation of electric components arranged thereon from the metal sheet of the IMS and additionally enables heat dissipation from the electric components to the metal sheet base.

LED modules of the prior art are disclosed in documents WO 2012/055852 A1, WO 2010/060420 A1 and US 2012/187830 A1. For connecting the LED Chips onto the IMS carrier, chip-on-board technique is usually applied. In addition to LED Chips, circuitry for current provision and current control for the LED Chips may be provided on the IMS carrier. A known solution is hereby the provision of the circuitry by means of surface mounted devices (SMD) on the carrier.

A problem that arises in such solutions is the restricted arrangement possibility of the electric parts on the IMS carrier. This is in particular due to the fact that the electric parts are usually connected to a surface of the IMS carrier after the provision of the LED Chips, as there exists the risk of the bond pads for the LED Chips on the carrier being contaminated in a soldering process for the electric parts. Accordingly, the area on the IMS carrier on which electric parts such as SMD parts may be arranged, as well as their particular orientation on the IMS carrier is limited. Therefore, complex circuitry and high populated circuits cannot be realized on these LED modules.

The present invention thus seeks to provide an enhanced IMS LED Module with complex circuitry, and which may be manufactured economically.

### Summary of the invention

In a first aspect, the invention relates to a LED Module comprising a first carrier with at least one LED Chip arranged thereon and a second carrier on which electric components for being connected to the at least one LED Chip are arranged, wherein the first carrier is an insulated metal substrate comprising a metal base material and a dielectric layer on which the at least one LED Chip is arranged, and wherein the second carrier is a sheet-shaped circuit board arranged to at least partially cover a top surface of the first carrier and which is electrically connected to the first carrier.

The first and second carrier are connected by means of an adhesive foil and the second carrier comprises dilatation means which are arranged to at least partially surround or encompass electric connection means of the first and second carrier. The dilatation means comprise linear grooves that extend radially from a central opening of the second carrier towards an outer circumference of the second carrier such that the electric connection means are situated between the linear grooves. The first and second carrier may thus be prefabricated individually and then joined together in order to form the LED module. Due to the independent manufacturing of the first and second carrier, the constraints as present in particular to the spatial arrangement of the electric components on the LED module are overcome. Moreover, the first and second carrier comprising the at least one LED chip respectively constituting the circuit board for the electric components of the LED module may be manufactured and tested individually before joining. Accordingly, more sophisticated and complex circuitry can be provided on the LED module without the necessity of increasing the dimensions of the LED module.

The second carrier is preferably arranged on the top surface of the first carrier such as to cover at least 50%, more preferably at least 65%, most preferably at least 75% of the top surface of the first carrier.

The second carrier is preferably arranged such as to at least partially surround the at least one LED Chip on the first carrier. In a preferred embodiment, the second carrier is essentially circular or ring-shaped. The second carrier preferably comprises at least one opening or through hole through which the at least one LED Chip of the first carrier protrudes. The at least one opening is preferably arranged in a central portion of the second carrier. The second carrier may comprise a plurality of openings or through holes through which the LED Chips of the first carrier protrude.

The second carrier constitutes a circuit board for mounting electric components thereon. The second carrier is preferably made from a material different than the material of the first carrier. The second carrier is preferably made from FR4 material. The electric components are preferably surface mounted devices (SMD) which are mounted onto the second carrier.

The first carrier is constituted by an insulated metal substrate. Thereby, the metal base layer material is preferably made by aluminium. The dielectric layer is preferably made from a ceramic material or an insulating resin material. The LED Chip is preferably arranged on the dielectric layer.

The at least one LED Chip is connected to the first carrier by means of chip-on-board technique. In a preferred embodiment, a plurality of LED chips is arranged on the first carrier. The LED Chips are preferably arranged in a central portion of the first carrier.

The at least one LED Chip is preferably encapsulated by a color conversion material. Thereby, a resin material such as a silicone matrix comprising color conversion particles may be applied onto the surface of the LED Chip. Accordingly, at least a portion of the primary light emitted by the LED chip is converted into a light of another wavelength. The light emitted by the color converted LED Chip is preferably white light.

The at least one LED chip is preferably covered by a dam- and-fill arrangement that may be formed on the top surface of the first carrier by means of a dispensing technique. Thereby, a surrounding dam is provided on the top surface of the first carrier, which is then filled by a color conversion material as described above.

In a preferred embodiment, the first carrier and the second carrier are connected such as to form a sandwich-like structure or laminate. Preferably, the outer contours of the second carrier essentially correspond to the outer contours of the first carrier. In a particularly preferred embodiment, the first and second carrier are preferably of essentially circular shape respectively disc-shaped.

The first and second carrier are preferably connected by at least partially flexible connecting means. The first and second carrier are connected by means of an adhesive foil. The adhesive foil may be a double-sided adhesive foil. The adhesive foil preferably comprises outer contours conformal to the first and/or second carrier. The adhesive foil may further comprise openings or recessions for enabling a connection between the first and second carrier. The openings or recessions may be provided in the portions in which the LED chips are arranged and/or in which an electric connection between the first and second carrier is present.

The first and second carrier may alternatively or additionally be connected by means of an electric connector or clamp. The clamp may be arranged at a lateral side of the first and second carrier thereby clamping the two carriers together.

The first and second carrier are electrically connected to each other. Thereby, the electric component of the second carrier are preferably connected to the at least one LED Chip of the first carrier.

The first and second carrier may be connected by means of a soldering connection. The first carrier preferably comprise soldering pads that are connected to conformably arranged soldering pads of the second carrier.

The soldering connection of the first and second carrier enables an electric connection of the carriers without the necessity for bulky connectors. Therefore, an integral and compact LED module is provided whereby the outer dimensions such as the width and the height of the LED module are reduced to a minimum. Thereby, the soldering connection merely requires for soldering pads in the bottom surface of the second carrier. Therefore, no wires or connection means have to protrude from the top surface of the second carrier. The soldering pads in the second carrier are designed to be soldered together with soldering pads in an upper surface of the first carrier.

For enabling a fixed and reliable connection between the first and second carrier, the LED module preferably comprises stress reducing means. Accordingly, material stresses which are caused when soldering the first and second carrier together can be minimized. Temperature caused stresses may in particular occur in case of the first and second carrier being made of different material and having different thermal expansion coefficients. For example in case of the metal base material of the first carrier being made from aluminium and the second carrier being made from FR4 material, the thermal expansion coefficients of these materials essentially differ which may cause stresses within the first and/or second carriers during and/or after the soldering process.

The stress reducing means of the LED module may comprise a specific orientation of the soldering pads present in the first and second carrier with respect to each other. In particular, the soldering pads of the first and second carrier are preferably arranged in close vicinity to each other. According to such an arrangement, the temperature caused stresses due to soldering the first and second carrier together are minimized. The first and second carrier are preferably soldered together by means of a low temperature solder. The melting point of the used solder is preferably lower than a melting point of a solder used for arranging the electric components on the second carrier. The low temperature solder used for connecting the first and second carrier preferably comprises a melting point of below 150°, preferably below 140°.

The stress reducing means of the LED module comprise dilatation means. The dilation means are comprised at least by the second carrier of the LED module. In addition, the first carrier may as well comprise dilatation means.

The dilatation means are arranged to at least partially surround or encompass the electric connection means of the first and second carrier such as the soldering pads. The dilatation means comprise linear. In other non-claimed embodiments, the dilatation means comprise curved grooves or through holes in the first and/or second carrier.

In a further aspect, the invention also relates to a lighting device such as preferably an LED Spotlight comprising an LED Module as outlined above.

### Brief description of the drawings

Further features, advantages and objects of the present invention will become apparent for a skilled person when reading the following detailed description of embodiments of the present invention, when taken in conjunction with the figures of the enclosed drawings.
- Fig. 1: is a perspective exploded assembly drawing of a non-claimed embodiment of the LED module.
- Fig. 2: is a perspective exploded assembly drawing of another non-claimed embodiment of the LED module, wherein the LED module comprises dilatation means.
- Fig. 3: is a perspective exploded assembly drawing of another preferred embodiment of the LED module corresponding to fig. 2 and wherein the LED module comprises alternative dilatation means.
- Fig. 4a and 4b: relate to perspective side views of a further non-claimed embodiment of the LED Module, in which the LED module comprises alternative dilatation means.

### Detailed description of the figures

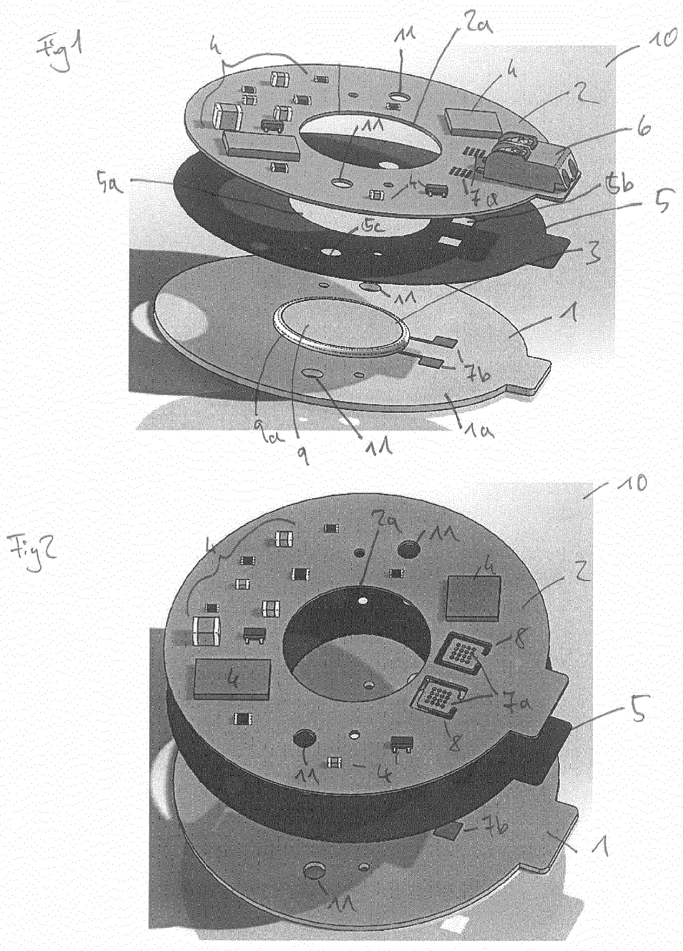

Figure 1 relates to a perspective assembly drawing of a non-claimed embodiment of the LED module 10.

The LED module 10 comprises a first carrier 1 being an insulated metal substrate (IMS). The IMS carrier 1 preferably comprises a metal base material (not shown), preferably aluminum, and a dielectric layer (1a) arranged to cover the metal base material. The dielectric layer may be made from ceramics or an insulating resin material. The IMS carrier 1 is preferably sheet-shaped, i.e. of homogenous thickness. The thickness of the first carrier 1 preferably lies between 1 and 5mm. The IMS carrier 1 is preferably of essentially circular shape when seen in top view. Notably, the carrier 1 may be of various shape such as rectangular or squared.

At least one LED Chip 3 is arranged in chip-on-board technique on the IMS carrier 1 and preferably on the top dielectric layer 1a thereof. In a preferred embodiment, a plurality of LED Chips 3 is arranged on the first carrier 1. The at least one LED Chip 3 respectively the plurality of LED chips 3 are preferably encapsulated by a color conversion material 9. The color conversion material 9 is preferably held by a dam 9a which surrounds the at least one LED chip or the plurality of LED chips 3. The color conversion material 9 and the dam 9a are preferably applied onto the first carrier 1 by means of a dam-and-fill process, in which the surrounding dam 9a is dispensed onto the surface of the first carrier 1 and the resulting recess within the dam is then filled with color conversion material 9 such as a phosphor particles comprising resin material.

The at least one LED Chip 3 is electrically contacted to the circumference of the color conversion material 9 by means of dedicated circuitry provided on the first carrier 1. The circuitry for the LED Chip 3 preferably comprises soldering pads or points 7b. The soldering pads 7b are thus arranged outside of the color conversion material 9. The at least one LED chip 3 is preferably arranged in a central portion of the first carrier 1.

The LED module further comprises a sheet-shaped second carrier 2 which constitutes a circuit board for supporting electric components 4 thereon. The second carrier 2 preferably comprises a homogenous thickness, which preferably lies in the range of 0.5 to 2mm.

The second carrier 2 is preferably made from a different material than the first carrier 1, such as e.g. FR4 material. The circuit board carrier 2 is preferably designed to comprise complex circuitry for supplying and controlling electric current for the LED chips 3 arranged on the first carrier. The circuitry of the second carrier comprises the mentioned electric components 4 and wiring for connecting the components. The electric components 4 are preferably surface mounted devices (SMD). The circuitry of the second carrier 2 may further comprise an electric connector or clamp 6 for connecting the LED module 10 to an external power supply. The second carrier 2 further comprises electric connection means for connecting the second carrier 2 to the first carrier 1. The electric connection means preferably comprise soldering pads or points 7a which are designed for being connected to dedicated soldering pads or points 7b of the first carrier. Accordingly, an electric connection between the first and second carrier 1,2 may be established by means of a soldering process. The soldering pads or points 7a are formed in a lower bottom portion or surface of the second carrier 2 and may extend through the whole carrier 2.

In the assembled state, the second carrier 2 preferably covers the top surface 1a of the first carrier 1 at least partially. In particular, the second carrier 2 is preferably arranged on the top surface 1a of the first carrier such as to cover at least 50%, more preferably at least 65%, most preferably at least 75% of the top surface 1a of the first carrier 1.

The second carrier 2 is preferably of conformal outer shape to the first carrier 1. This means that the outer contours of the first and second carrier 1,2, when seen in top view, preferably correspond. Thereby, the second carrier 2 is preferably of essentially circular shape. A central opening or through hole 2a is preferably provided in the second carrier 2, through which the LED chip 3 of the first carrier 1 protrudes in the assembled state of the first and second carrier 1,2.

The first and second carrier 1,2 are preferably connected to each other by means of an adhesive foil 5. Accordingly, the LED module 10 comprises a sandwich-like structure in which a bottom layer is constituted by the first carrier 1, a middle layer is constituted by the adhesive foil 5 and the top layer is constituted by the second carrier 2.

The adhesive foil 5 is preferably at least partially flexible. The foil 5 is preferably of conformal outer shape to the first and/or second carrier 1,2 as shown in figure 1. Thereby, the adhesive foil 5 may comprise dedicated openings 5a,5b,5c which correspond to openings provided in the first and/or second carrier 1,2. In particular, the adhesive foil 5 preferably comprises a central opening 5a for the LED chip or chips 3. The foil 5 preferably also comprises openings 5b which are formed such that the soldering pads of the first and second carrier 1,2 may be connected. The foil 5 may additionally comprise openings 5c conformally shaped to fixation openings 11 in the first and second carrier 1,2. By means of said fixation openings or holes 11, the LED module 11 may be fixedly connected to a housing of a lighting device such as an LED spotlight by means of screws or other suitable connecting members.

The first and second carrier 1,2 are thus connected by means of the adhesive foil 5. Thereby, the electric components and circuitry is preferably arranged solely on an upper surface of the second carrier 2, opposite to the surface of the carrier 2 to which the foil 5 is connected. The first and second carrier 1,2 are additionally connected by means of the soldering connection of the solder pads 7b of the first carrier 1 and the solder pads 7a of the second carrier 2. Thereby, in order to reduce the temperature caused stress in the LED module 1, the solder pads 7a,7b of the first and second carrier 1,2 are preferably arranged in close vicinity to each other. In particular, a lateral maximum distance between the respective solder pads 7a,7b in the first and second carrier 1,2 is preferably below 3 mm, and preferably between 0.1 and 2 mm, more preferably between 0.2 and 1mm.

Figure 2 shows a perspective exploded assembly drawing of another non-claimed embodiment of the LED module, wherein the LED module 10 comprises dilatation means 8. The structure of the LED module 10 according to this embodiment essentially corresponds to the structure according to figure 1. Thereby however, the second carrier 2 comprises stress reducing means in the form of dilatation means 8 which are designed to further minimize the temperature caused stress in the first and second carrier 1,2 obtained during the soldering process.

As shown in the figure, the dilatation means 8 comprise grooves which essentially surround or encompass the soldering pads 7a of the second carrier 2. Accordingly, an expansion of the material of the solder pads 7a of the first carrier 2 in the soldering process may be compensated by the dilatation means 8. These dilatation means 8 in conjunction with the provided adhesive foil 5 thus enable to provide a certain flexibility of the laminated LED module 10 which compensates for temperature induced stress within the first and/or second carrier 1,2. The grooves preferably comprise a lateral width of between 0.5 and 3mm, preferably between 1 and 2mm. The grooves 8 are preferably arranged in an essentially rectangular or squared pattern about the circumference of the soldering pads 7a.

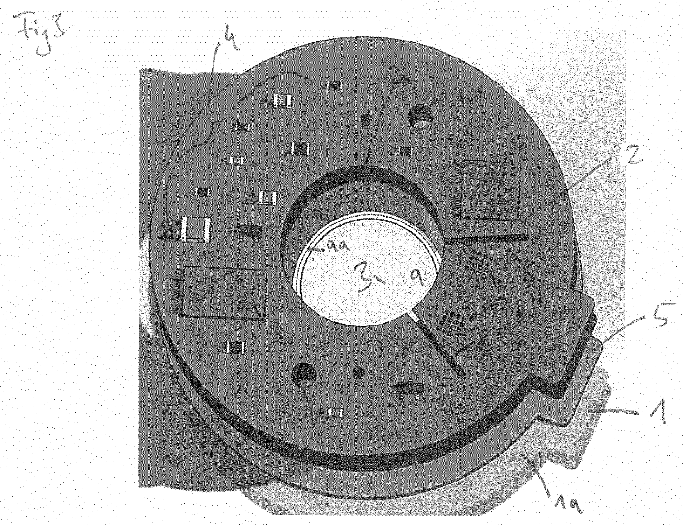

Figure 3 relates to another preferred embodiment according to the invention, in which the second carrier 2 comprises alternative dilatation means 8. The rest of the structure of the LED module 10 according to this embodiment essentially corresponds to the structure according to the embodiment in figure 1 and 2. In this embodiment, the dilatation means 8 comprise linear grooves or cut-outs. The linear grooves extend from a central opening 2a of the second carrier 2 towards the outer circumference of the second carrier 2 such that the solder pads 7a are situated between the linear grooves 8. The linear grooves extend preferably radially from the central opening 2a. As mentioned with respect to the embodiment in figure 2, the grooves preferably comprise a lateral width of between 0.5 and 3mm, preferably between 1 and 2mm.

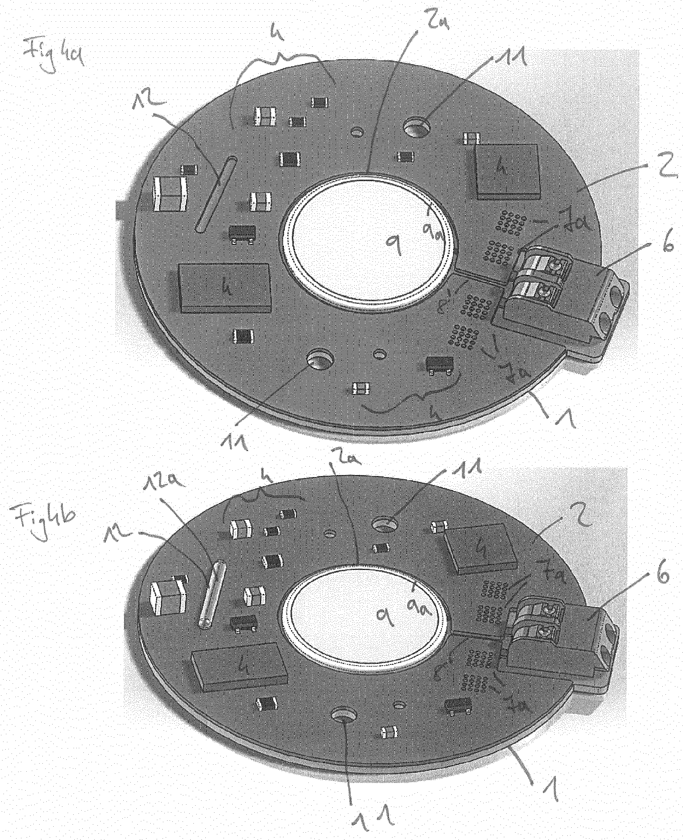

Figures 4a and 4b relate to an alternative non-claimed embodiment of the LED module according to the invention, in which the LED module 10 comprises alternative stress reducing means. In this embodiment, the first and second carrier 1,2 are preferably held together by means of mechanical connection means. In particular, a mechanical connector 6 is laterally arranged and designed to exert a clamping force onto the first and second carrier 1, 2, thereby holding the carriers 1,2 together. The connector 6 exerts a clamping force onto an outer lateral portion of the first and second carrier 1,2. Thereby, preferably no adhesive foil is arranged between the first and second carrier 1,2. In a lateral portion of the second carrier 2, opposite to the connector 6, a preferably linear groove or cut-out 12 is formed. In order to enable a slightly flexible connection between the first and second carrier 1,2, the linear groove 12 is preferably filled with a resin material 12a such as a silicone material (see fig. 4b). The resin material 12a may be applied into the linear groove 12 and thus onto the surface 1a of the first carrier 1 in a dispensing process. The resin material 12a then protrudes from the upper top surface 1a of the first carrier 1 into the recess 12. When hardened respectively cured, the resin material 12a is restricted by the inner contours of the recess 12 such that a lateral movement of the first and second carrier 1,2 with respect to each other is essentially prevented. However, due to the nature of the used resin material, a certain flexibility of the first and second carrier 1,2 is maintained such that temperature induced stress due to the soldering of the first and second carrier 1,2 can be compensated. As shown in figures 4a,4b, the LED module 10 according to this embodiment may additionally comprise dilatation means 8' such as a linear groove extending from the central aperture 2a towards the connector 6. Thereby, the solder pads 7a may be arranged on both sides of the linear groove 8'. Notably, the LED module 10 may comprise additional dilatation means 8 of alternative form such as e.g described with respect to the embodiments shown in figures 2 and 3.

## Claims

1. A LED Module (10) comprising a first carrier (1) with at least one LED Chip (3) arranged thereon and a second carrier (2) on which electric components (4) for being connected to the at least one LED Chip (3) are arranged,
wherein the first carrier (1) is an insulated metal substrate comprising a metal base material and a dielectric layer on which the at least one LED Chip (3) is arranged,
wherein the second carrier (2) is a sheet-shaped circuit board arranged to at least partially cover a top surface of the first carrier (1) and which is electrically connected to the first carrier (1), and wherein the second carrier (2) comprises dilatation means (8) which are arranged to at least partially surround or encompass electric connection means (7a) of the first and second carrier, **characterized in that** the first and second carrier (1, 2) are connected by means of an adhesive foil (5), and **in that** the dilatation means (8) comprise linear grooves that extend radially from a central opening (2a) of the second carrier (2) towards an outer circumference of the second carrier such that the electric connection means (7a) are situated between the linear grooves.

2. The LED Module according to claim 1, wherein the second carrier (2) is arranged to essentially surround the at least one LED chip (3) of the first carrier (1) .

3. The LED Module according to claim 1 or 2, wherein the second carrier (2) comprises an opening or through hole (2a) through which the at least one LED Chip (3) of the first carrier (1) protrudes.

4. The LED Module according to claims 1 to 3, wherein the second carrier (2) is made from FR4 material.

5. The LED Module according to any of the preceding claims, wherein the at least one LED Chip (3) is connected to the first carrier (1) by means of chip-on-board technique.

6. The LED Module according to any of the preceding claims, wherein the electric components (4) on the second carrier (2) as surface mounted devices (SMD).

7. The LED Module according to any of the preceding claims, wherein the first carrier (1) and the second carrier (2) are connected in sandwich-like structure.

8. The LED module according to any of the preceding claims, wherein the first and second carrier (1,2) are connected at least by partially flexible connection means (5, 12a).

9. The LED Module according to any of the preceding claims, wherein the outer contours of the second carrier (2) essentially correspond to the outer contours of the first carrier (1).

10. The LED Module according to any of the preceding claims, wherein the first and second carriers (1,2) are connected by means of a laterally arranged electric connector clamp (6) of the LED Module.

11. The LED Module according to any of the preceding claims, wherein the first and second carriers (1,2) are electrically connected by means of a soldering connection (7a,7b).

12. The LED Module according to claim 11, wherein the soldering points (7a,7b) of the first and second carrier (1,2) are situated in close vicinity to each other.

13. LED Spotlight comprising an LED Module according to claims 1 to 12.

## Patentansprüche

1. LED-Modul (10), umfassend einen ersten Träger (1), auf dem mindestens einem LED-Chip (3) angeordnet ist, und einem zweiten Träger (2), auf dem elektrische Komponenten (4) zum Anschluss an den mindestens einen LED-Chip (3) angeordnet sind,
wobei der erste Träger (1) ein isoliertes Metallsubstrat ist, das einen metallischen Grundwerkstoff und eine dielektrische Schicht, auf der der mindestens eine LED-Chip (3) angeordnet ist, umfasst,
wobei der zweite Träger (2) eine blattförmige Leiterplatte ist, die derart angeordnet ist, dass sie eine Oberseite des ersten Trägers (1) mindestens teilweise deckt, und die an den ersten Träger (1) elektrisch angeschlossen ist, und
wobei der zweite Träger (2) Ausdehnungsmittel (8) umfasst, die derart angeordnet sind, dass sie elektrische Verbindungsmittel (7a) des ersten und zweiten Trägers mindestens teilweise umgeben oder umschließen, **dadurch gekennzeichnet, dass** der erste und zweite Träger (1, 2) durch eine Klebefolie (5) verbunden sind, und dass
die Erweiterungsmittel (8) lineare Nuten umfassen, die sich radial von einer zentralen Öffnung (2a) des zweiten Trägers (2) in Richtung eines Außenumfangs des zweiten Trägers erstrecken, so dass die elektrischen Verbindungsmittel (7a) zwischen den linearen Nuten angeordnet sind.

2. LED-Modul nach Anspruch 1, wobei der zweite Träger (2) derart angeordnet ist, dass er den mindestens einen LED-Chip (3) des ersten Trägers (1) im Wesentlichen umgibt.

3. LED-Modul nach Anspruch 1 oder 2, wobei der zweite Träger (2) eine Öffnung oder Durchgangsöffnung (2a) umfasst, durch die der mindestens eine LED-Chip (3) des ersten Trägers (1) herausragt.

4. LED-Modul nach Anspruch 1 - 3, wobei der zweite Träger (2) aus FR4-Material besteht.

5. LED-Modul nach einem der vorstehenden Ansprüche, wobei der mindestens eine LED-Chip (3) mittels Chip-on-Board-Technik mit dem ersten Träger (1) verbunden ist.

6. LED-Modul nach einem der vorstehenden Ansprüche, wobei die elektrischen Komponenten (4) auf dem zweiten Träger (2) oberflächenmontierbare Bauelemente (SMD) sind.

7. LED-Modul nach einem der vorstehenden Ansprüche, wobei der erste Träger (1) und der zweite Träger (2) sandwichartig verbunden sind.

8. LED-Modul nach einem der vorstehenden Ansprüche, wobei der erste und zweite Träger (1, 2) mindestens durch teilweise flexible Verbindungsmittel (5, 12a) verbunden sind.

9. LED-Modul nach einem der vorstehenden Ansprüche, wobei die äußeren Konturen des zweiten Trägers (2) im Wesentlichen den äußeren Konturen des ersten Trägers (1) entsprechen.

10. LED-Modul nach einem der vorstehenden Ansprüche, wobei der erste und zweite Träger (1, 2) mittels einer seitlich angeordneten elektrischen Anschlussklemme (6) des LED-Moduls verbunden sind.

11. LED-Modul nach einem der vorstehenden Ansprüche, wobei der erste und zweite Träger (1, 2) durch eine Lötverbindung (7a, 7b) elektrisch verbunden sind.

12. LED-Modul nach Anspruch 11, wobei die Lötstellen (7a, 7b) des ersten und zweiten Trägers (1, 2) in unmittelbarer Nähe zueinander angeordnet sind.

13. LED-Strahler, umfassend ein LED-Modul nach den Ansprüchen 1 - 12.

## Revendications

1. Module LED (10) comprenant un premier support (1) avec au moins une puce à LED (3) disposée dessus et un deuxième support (2) sur lequel des composants électriques (4) sont disposés afin d'être connectés à l'au moins une puce à LED (3),
dans lequel le premier support (1) est un substrat métallique isolé comprenant une matériau à base de métal et une couche diélectrique sur laquelle l'au moins une puce à LED (3) est disposé,
dans lequel le deuxième support (2) est un circuit imprimé en forme de feuille conçu pour recouvrir au moins partiellement une surface supérieure du premier support (1) et qui est connecté électriquement au premier support (1) et
dans lequel le deuxième support (2) comprend des moyens de dilatation (8) qui sont conçus pour entourer ou inclure au moins partiellement des moyens de connexion électrique (7a) du premier et du deuxième supports, **caractérisé en ce que** le premier et le deuxième supports (1, 2) sont connectés à l'aide d'un film adhésif (5) et **en ce que**
les moyens de dilatation (8) comprennent des rainures linéaires qui s'étendent radialement à partir d'une ouverture centrale (2a) du deuxième support (2) en direction d'une circonférence externe du deuxième support de façon à ce que les moyens de connexion électrique (7a) soient situés entre les rainures linéaires.

2. Module LED selon la revendication 1, dans lequel le deuxième support (2) est conçu pour entourer essentiellement l'au moins une puce à LED (3) du premier support (1).

3. Module LED selon la revendication 1 ou 2, dans lequel le deuxième support (2) comprend une ouverture ou un trou traversant (2a) à travers lequel dépasse l'au moins une puce à LED (3) du premier support (1).

4. Module LED selon l'une des revendications 1 à 3, dans lequel le deuxième support (2) est constitué d'un matériau FR4.

5. Module LED selon l'une des revendications précédentes, dans lequel l'au moins une puce à LED (3) est connectée au premier support (1) à l'aide d'une technologie « chip-on-board ».

6. Module LED selon l'une des revendications précédentes, dans lequel les composants électriques (4) sur le deuxième support (2) sont conçus comme des dispositifs montés en surface (SMD).

7. Module LED selon l'une des revendications précédentes, dans lequel le premier support (1) et le deuxième support (2) sont connectés dans une structure en sandwich.

8. Module LED selon l'une des revendications précédentes, dans lequel le premier et le deuxième supports (1, 2) sont connectés à l'aide de moyens de connexion (5, 12a) au moins partiellement flexibles.

9. Module LED selon l'une des revendications précédentes, dans lequel les contours externes du deuxième support (2) correspondent essentiellement aux contours externes du premier support (1).

10. Module LED selon l'une des revendications précédentes, dans lequel le premier et le deuxième supports (1, 2) sont connectés à l'aide d'une pince de connecteur électrique (6), disposée latéralement, du module LED.

11. Module LED selon l'une des revendications précédentes, dans lequel le premier et le deuxième supports (1, 2) sont connectés électriquement à l'aide d'une connexion par brasage (7a, 7b).

12. Module LED selon la revendication 11, dans lequel les points de brasage (7a, 7b) du premier et du deuxième supports (1, 2) sont situés très près les uns des autres.

13. Spot à LED comprenant un module LED selon les revendications 1 à 12.
